# EUROPEAN PATENT APPLICATION

(11) **EP 2 093 616 A1**
(43) Date of publication of application: **26.08.2009**
(21) Application number: 09153324.0
(22) Date of filing: 20.02.2009
(51) Int. Cl.: G03F 7/20, G03F 1/14

(54) **Split and design guidelines for double patterning**

(30) Priority: 22.02.2008 US 30922 P; 17.07.2008 EP 08160666
(71) Applicant: IMEC, 3001 Leuven (BE)
(72) Inventor: Wiaux, Vincent Jean-Marie Pierre Paul, 1348 Louvain-la-Neuve (BE); Verhaegen, Gustaaf, 2580 Putte (BE)
(74) Representative: Wauters, Davy Erik Angelo

(57) **Abstract**

A method (100) for setting up multiple patterning lithographic processing of a pattern in a single layer is described. The multiple patterning lithographic processing comprises a first patterning step and at least a second patterning step. The method comprises, for at least one process condition, obtaining (130) values for at least one metric expressing a splitting correlated process quality as function of design features patterned as function of design parameters of a pattern and/or split parameters for the multiple patterning lithographic processing. The method also comprises evaluating (140) said values of the at least one metric and selecting based thereon design and split parameters taking into account the at least one process condition. The method (100) further comprises deriving design and/or split guidelines (170) for splitting patterns to be processed using multiple patterning lithographic processing based on the evaluation.

## Description

### Technical field of the invention

The present invention relates to the field of lithographic processing, used e.g. in the manufacturing of semiconductor devices such as integrated circuits, and process optimisation in general. More particularly, the present invention relates to methods and systems for optimising double patterning techniques for lithographic processing, to devices thus obtained and to lithographic masks used with such methods for double patterning techniques.

### Background of the invention

Extending the use of immersion lithography to the 32 nm node and beyond using the highest numerical aperture of 1.35 requires the patterning of features at aggressive k1 values. Although the 45nm half-pitch node still correspond to k1 values above the physical limit of 0.25, and consequently single patterning as well as double patterning both are potential solutions, single patterning solutions require off-axis illumination and restricted design rules, thus limiting the ease of implementation. For random logic designs, single patterning may for example be only implemented at the expense of a design change. Double patterning (DP) or double exposure (DE) in lithography may be an alternative solution to meet 45 nm half pitch node requirements and beyond. It further extends the use of water immersion lithography at its maximum numerical aperture NA=1.35. One of the aims of double patterning is to make lithographic processing of dense features possible by splitting a design into two more sparse designs and by recombining into the target pattern through a double patterning flow. It suppresses interactions between the two images in resist.

The complexity of design split, required when applying double patterning, strongly depends on the pattern density and its 2D content. Consequently, a lot of attention is needed for devices with a dense pattern. In order to apply double patterning the design is cut and split, such as for example when splitting up random logic patterns. In double patterning of random logic applications with small pitch, distributing existing polygons on two separate designs may not be sufficient. Often cutting of such polygons is required. However, this results in creating new line-ends that need to recombine during the double patterning process at so-called stitching points.

The 2D printability of the patterns needs to be taken into account to validate the benefit of a split. Indeed, small gaps at line-ends and critical 2D topologies are as important as sub-resolution or forbidden pitches. Because the cutting of polygons is not always sufficient to solve the split conflicts, there is a need for split- or even design- rules to ensure the benefit of double patterning.

### Summary of the invention

It is an object of embodiments of the present invention to provide good apparatus or methods for optimizing lithographic processing, e.g. setting up good lithographic processing. It is an advantage of embodiments according to the present invention that good systems and methods are provided for optimizing a double patterning process used in lithographic processing, e.g. for setting up good double patterning processes used in lithographic processing.

It is an advantage of embodiments according to the present invention that methods and systems are provided allowing appropriate selection of process conditions by optimizing the process window for obtaining appropriate lithographic processing of patterns in a single layer.

It is an advantage of embodiments according to the present invention that these provide robust stitching through process variations for lithographic processing using double patterning.

It is an advantage of embodiments according to the present invention that cutting of polygons in the design for double patterning may be a suitable solution to colouring, i.e. the assigning of polygons or parts thereof to two different layers to be patterned separately, because methods and systems are provided allowing recombination of polygons in a robust way through double patterning process variations.

It is an advantage of embodiments according to the present invention that methods and systems are provided allowing good design for manufacturing.

It is an advantage of embodiments according to the present invention that good methods and systems are provided for designing devices such as for example integrated circuits and/or electronic circuits and corresponding manufacturing techniques.

It is an advantage of embodiments according to the present invention that methods and systems are provided allowing robust and efficient lithographic processing. It is an advantage of embodiments according to the present invention that good lithographic processing can be obtained, even under various or varying process conditions.

The above objective is accomplished by a method and device according to the present invention.

The present invention relates to a method for optimizing multiple patterning lithographic processing of a pattern in a single layer e.g. by setting up multiple patterning lithographic processing for processing a pattern in a single layer, the pattern comprising a plurality of design features, the multiple patterning lithographic processing comprising a first patterning step and at least a second patterning step, the method comprising, for at least one and optionally a plurality of process conditions,
obtaining values for at least one metric expressing a splitting correlated process quality as function of design parameters of a pattern and/or split parameters for the multiple patterning lithographic processing, and evaluating said values of the at least one metric as function of design parameters of the pattern and/or as function of split parameters taking into account said at least one process condition. It is an advantage of embodiments according to the present invention that double patterning lithographic processing can be optimized as function of the at least one process condition. Said evaluating of the values for the metric may be performed with respect to predetermined criteria. The method furthermore comprises deriving design and/or split guidelines for splitting patterns to be processed using multiple patterning lithographic processing based on said evaluating.

Obtaining values for at least one metric expressing a splitting correlated process quality may comprise obtaining values for at least one metric expressing a stitching correlated process quality.

Obtaining values for at least one metric expressing a stitching correlated process quality may comprise obtaining values for a parameter expressing a degree of stitching between design features patterned in the first patterning step and design features patterned in the at least a second patterning step.

Said evaluating values of the at least one metric may comprise evaluating whether the stitching width, being the smallest internal distance between merged contours of the design features patterned in the first patterning step and the design features patterned in the second patterning step, is larger than a predetermined value. It is an advantage of embodiments according to the present invention that a good metric for expressing splitting quality, e.g. stitching quality and stitching failure, is used. An insufficient stitching quality may be determined by a stitching width being smaller than a predetermined value, such as e.g. smaller than 90% of the nominal critical dimension obtainable or 60% of the nominal critical dimension obtainable or 30% of the nominal critical dimension obtainable or 10% of the nominal critical dimension obtainable.

The metric expressing a splitting correlated process quality may comprise any of a circuit performance, an electric metric or a patterning metric. It may for example comprise reliability as quality parameter. The method may furthermore comprise determining values for at least one further metric, not correlated to the splitting process, the metric expressing an incomplete optical proximity correction, for expressing bridging and/or for expressing pinching as function of design parameters of the pattern and/or splitting parameters for the multiple patterning lithographic processing and evaluating said at least one further metric. It is an advantage according to embodiments of the present invention that different process failure causes can be taken into account simultaneously.

For evaluating said values of the at least one metric as function of a first, second and third design parameter and/or split parameter, the method may comprise topologically organising said values of said at least one metric so that for a given value of the first and second design parameter and/or split parameter, values of the at least one metric are positioned equidistant for subsequent values of the third design and/or split parameter in said topologically organised values. It is an advantage of embodiments according to the present invention that a large number of design parameters and/or process parameters can be taken into account for evaluating the at least one metric. It is an advantage of embodiments according to the present invention that a good comparison between metric values can be obtained, such that for example a size for a usable process window can be relatively easy determined. The topologically organised values may be organised in matrix form.

Evaluating values of the at least one metric may comprise determining a process window for performing said lithographic processing so as to obtain a predetermined value for the metric expressing the splitting correlated process quality. It is an advantage of embodiments according to the present invention that a process window for the lithographic processing can be determined wherein the splitting, e.g. stitching, is appropriate throughout the process window.

The method thus comprises, based on said evaluating, deriving design and/or split guidelines for splitting patterns to be processed using multiple patterning lithographic processing. It is an advantage of embodiments according to the present invention that for appropriate test structures suitable information can be obtained in general, without the need for performing this for each specific structure in the devices to be made. Obtaining a value may be performed based on simulation of the multiple patterning lithographic process. Obtaining a value may be performed based on experimentally obtained measurement data. Obtaining a value may be performed by determining, e.g. experimentally, a value for the at least one metric for a plurality of test structures under a plurality of process conditions.

The method further may comprise, based on the design and/or split guidelines, deriving working values for design settings and/or split settings for multiple patterning lithographic processing of a pattern in a single layer. Obtaining values for at least one metric may be performed for a test pattern and determining an initial design, e.g. a splitted design, taking into account the derived design and/or split guidelines, for a further pattern to be processed with the multiple patterning lithographic processing.

The present invention also relates to a design for test patterns, wherein the test patterns are adapted for use in a method for optimising multiple patterning lithographic processing of a pattern e.g. by setting up multiple patterning lithographic processing for processing a pattern in a single layer as described above.

The present invention also relates to a design for test patterns comprising a plurality of features for being processed, the design being a split design comprising a first sub-design with a first set of sub-features and at least a second sub-design with a second set of sub-features so as to obtain said plurality of features when using the design for multiple patterning lithographic processing, wherein said plurality of features have at least one parameterised property so that a systematic variation of the property between different features is present.

The plurality of features may comprise a first, a second and a third parameterised property, whereby the features may be topologically organised so that features having the same value for the first parameterised property are positioned equidistant from each other, features comprising the same value for the second parameterised property are positioned equidistant and features comprising the same value for the third parameterised property are positioned equidistant from each other.

The present invention furthermore relates to a set of reticles for optimising multiple patterning lithographic processing of a pattern in a single layer e.g. by setting up multiple patterning lithographic processing for processing a pattern in a single layer, the reticles comprising test patterns according to a design as described above.

The present invention also relates to a system for optimising multiple patterning lithographic processing of a pattern in a single layer e.g. by setting up multiple patterning lithographic processing for processing a pattern in a single layer, the pattern comprising a plurality of design features, the multiple patterning lithographic processing comprising at least a first patterning step and a second patterning step, the system comprising a metric determination means for obtaining, for at least one and optionally a plurality of process conditions, values for a metric expressing a splitting correlated process quality as function of design parameters of the pattern and/or split parameters for the double patterning lithographic processing, and an evaluation means for evaluating said values of the at least one metric as function of the design and/or split parameters taking into account said at least one process condition. The splitting correlated process quality may be a stitching correlated process quality.

The invention also relates to a method for multiple patterning lithographic processing of a pattern in a single layer, wherein the method comprises splitting a design to be patterned according to predetermined splitting rules in a first set of design features and a the at least a second set of design features, performing a first patterning step for the first set of pattern features and a second patterning step for second set of pattern features, wherein said predetermined splitting rules are obtained using a method for optimising multiple patterning lithographic processing e.g. by setting up multiple patterning lithographic processing for processing a pattern in a single layer as described above. The present invention also relates to a reticle or set of reticles optimised using a method according to an embodiment of the present invention. The first set of design features and the at least a second set of design features used in the multiple patterning lithographic processing thereby may combine to the target pattern to be applied in the layer.

The present invention furthermore relates to a device made by multiple patterning lithographic processing, the device being made with a multiple patterning lithographic processing of a pattern in a single layer optimised, e.g. set up using a method according to an embodiment of the present invention.

The present invention also relates to a computer program product adapted for, when executed on a computer, performing the method of optimizing, e.g. setting up, multiple patterning lithographic processing of a pattern in a single layer as described above. The present invention also relates to a machine readable data storage device storing the computer program product as described above and/or to the transmission of the computer program product as described above over a local or wide area telecommunications network.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The teachings of the present invention permit the design of improved lithographic processing methods, having a good yield, thus resulting in good lithographically processed devices fulfilling the required specifications.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 a and 1 b illustrates two types of design splitting, whereby in FIG. 1 b an example of a cut and split design is illustrated, as can be used in embodiments according to the present invention.
FIG. 2 is a schematic overview of an exemplary method for optimising, e.g. setting up, multiple patterning lithographic processing according to an embodiment of the present invention.
FIG. 3 illustrates examples of split test patterns (right hand side) representative for splitting a pattern (left hand side) that can be used in a random logic metal layout.
FIG. 4 is a schematic illustration of the stitching width as exemplary metric for a double patterning lithographic patterning process, as can be used according to an embodiment of the present invention.
FIG. 5 is a schematic illustration of imaging failures and stitching failure effects that may occur in a multiple patterning lithographic process and which can be taken into account using methods according to embodiments of the present invention. Incomplete optical proximity correction, bridging, pinching and stitching failure is shown (from left to right).
FIG. 6 is a schematic representation of a sub-matrix for representation of a metric expressing a degree of stitching as can be used in an embodiment according to the present invention.
FIG. 7 is a schematic representation of a larger matrix comprising sub-matrices for representation of a metric expressing a degree of stitching as function of a plurality of variables as can be used in an embodiment according to the present invention.
FIG. 8 is a schematic representation of process window variations used in an example for optimising a multiple pattern lithographic process according to an embodiment of the present invention.
FIG. 9 illustrates how stitching overlap on the mask compensates for trench-end shortening and trench-end rounding in detuned process conditions, more than for overlay, as can be derived using a method according to an embodiment of the present invention.
FIG. 10 illustrates results for study of stitching of parallel trenches, as can be obtained using a method according to an embodiment of the present invention.
FIG. 11 illustrates the impact on the stitching width of overlay error along the stitching direction or perpendicular thereto, as can be obtained using a method according to an embodiment of the present invention.
FIG. 12 illustrates how the stitching overlap re-introduces partially a dense pitch and small gap as can be obtained using a method according to an embodiment of the present invention.
FIG. 13. Illustrates for parallel trenches with cut, an analysis of the overlap-pitch domain for stitching without process failure, wherein a large overlap re-introduces a dense pitch, resulting in stitching and bridging failures at NA 1.35 and wherein it is illustrated that colouring is not an issue at any pitch, and that a robust stitching is only possible at relaxed pitches, as can be obtained using a method according to an embodiment of the present invention.
FIG. 14 illustrates that for a numerical aperture of 1.2, a large overlap re-introduces a dense pitch, resulting in stitching, bridging and OPC failures, as can be derived using a method according to an embodiment of the present invention.
FIG. 15 illustrates that relaxing gaps can be required to avoid bridging and ensuring a robust stitching in lines, as can be derived using a method according to an embodiment of the present invention.
FIG. 16 indicates a comparison of pitch-gap minimisation without process failure for single patterning and double patterning at numerical aperture of 1.2 and 1.35 indicating two possible split solutions leading to different resolution limits as can be derived using a method according to an embodiment of the present invention.
FIG. 17 illustrates pitch and gap resolution limits for the pattern shown in FIG. 16.
FIG. 18 illustrates double patterning results for trenches as can be obtained using a method for optimising the double patterning process according to an embodiment of the present invention.
FIG. 19 illustrates a system for optimising a multiple patterning lithographic process according to an embodiment of the present invention.
FIG. 20 illustrates a test pattern comprising a plurality of parallel lines, as can be used in an embodiment of the present invention.
FIG. 21 illustrates a test pattern comprising a plurality of cornered lines as can be used in an embodiment of the present invention.
FIG. 22 illustrates a test pattern comprising a plurality of zigzag lines, as can be used in an embodiment of the present invention.
FIG. 23 illustrates a test pattern comprising a jog as can be used in an embodiment of the present invention.
FIG. 24 illustrates a processing means adapted for performing a method for optimising, e.g. setting up, multiple patterning lithographic processing according to an embodiment of the present invention.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

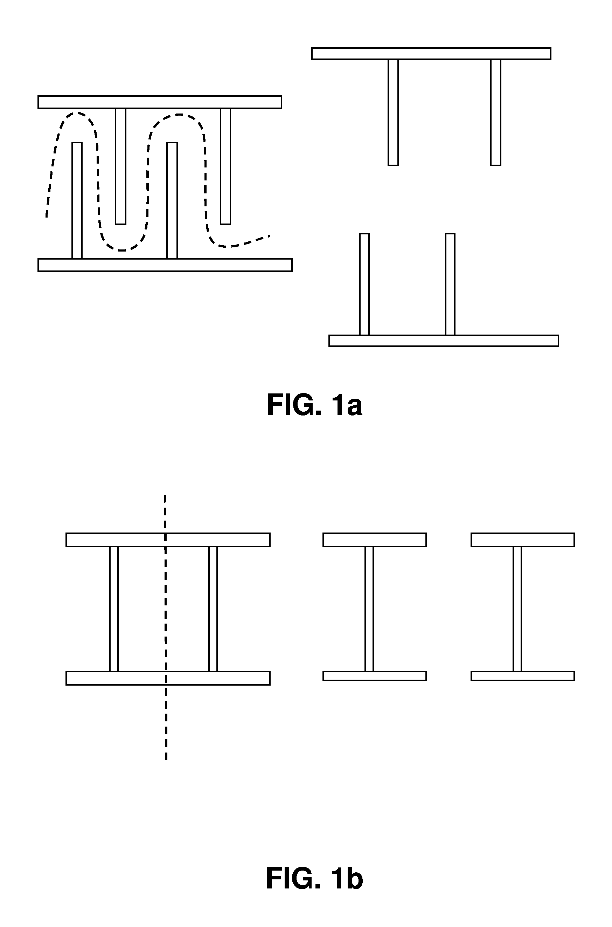

In the present application, when reference is made to splitting or design splitting, reference is made to the division of design features in two or more sets of features, the design features being design features of a pattern to be applied in a single layer. The latter thus results in the application of multiple patterning for forming a pattern in a single layer. Splitting of the design also may refer to cutting and stitching, i.e. cutting of certain features in sub-features, at least partly patterning them and stitching the sub-features together so as to obtain the features as targeted in the single layer. Splitting thus refers to both dividing in between features and cutting features in smaller pieces and thereafter bringing them back together after at least part of the processing. Cutting and stitching thus refers only to cutting on the features so that different sub-features being part of the feature are created and brought back together after at least part of the processing. FIG. 1a and FIG. 1b. both illustrate examples of design splitting patterns, whereas only the second example (FIG. 1 b) illustrates an example of a cutting and stitching pattern. The first example (FIG. 1 a) illustrates an example of dividing a set of design features into two separate subsets of design features. The dashed line illustrates for both examples the splitting line. In both schematic figures, the original pattern is given on the left hand side whereas the split pattern is given on the right hand side.

The invention will now be described by a detailed description of several embodiments of the invention. It is clear that other embodiments of the invention can be configured according to the knowledge of persons skilled in the art. The invention is limited only by the terms of the appended claims.

In a first aspect, the present invention relates to a method for optimising multiple patterning lithographic processing of a pattern in a single layer comprising a plurality of design features e.g. by setting up multiple patterning lithographic processing for processing a pattern in a single layer. Such multiple patterning lithographic processing may for example be double patterning processing, whereby the creation of features in a pattern in a single layer comprises at least a first patterning step and a second patterning step. Alternatively, creation of features in a pattern using more than 2 patterning steps before developing the resist also is envisaged. According to embodiments of the present invention, the optimisation method e.g. method for setting up comprises, for at least one process condition, optionally for a plurality of process conditions, obtaining values for at least one metric expressing a splitting correlated process quality as function of design parameters and/or split parameters for the multiple patterning lithographic processing. The metric may be expressing a stitching correlated process quality. It is to be noticed that, whereas the method already provides advantages for optimising splitting processes, the method is especially suitable for the particular category of cut and stitching of designs. The metric may express an electric property, a patterning property, a circuit performance, ... that is a function of the stitching process that is performed. The metric may for example express the lack of bridging occurring around the stitching point. The metric may also be directly express a stitching parameter, for example it may express a degree of stitching between design features patterned in the first patterning and design features patterned in the second patterning step.

These values for the at least one metric thereby are obtained as function of design parameters of the pattern and/or split parameters for the multiple patterning lithographic processing. The method also comprises evaluating the values of the at least one metric as function of design and/or split parameters taking into account the plurality of process conditions. Furthermore, the method may comprise selecting, based on the evaluation, the design and split parameters to be used in a particular application thereby taking into account the at least one process condition and optionally evaluation for a plurality of process conditions. Alternatively or in addition thereto, the method furthermore may comprise determining, based on the evaluation, guidelines for design and/or split parameters. In some embodiments according to the present invention, taking into account the plurality of process conditions comprises selecting the design and split parameters so that good metric values are obtained for a sufficiently large process window. Furthermore, for setting up the lithographic processing, an initial design for a pattern to be processed can be determined taking into account the derived guidelines for design and/or split parameters.

For complex structures to be patterned, methods of multiple patterning may be subject to split, including cut and stitch, restrictions and design restrictions. The methods of multiple patterning may assist in determination of split parameters for performing appropriate splitting in order to obtain good multiple patterning lithographic processing. The latter may for example involve complex polygon splitting. Methods according to the present invention may be especially suitable for complex structures, such as for example random logic structures, although the invention is not limited thereto. It is an advantage of embodiments according to the present invention that good split and design guidelines can be derived for ensuring robust splitting, e.g. stitching, through process variations for multiple patterning lithographic processing of patterns. In other words, embodiments of the present invention allow to identify a parameter space in which the splitting, e.g. stitching, obtained is robust through process variations. It is an advantage of embodiments according to the present invention that guidelines for design parameters and/or splitting parameters for structures to be patterned using multiple patterning lithographic processing can be derived, even for structures with added complexity.

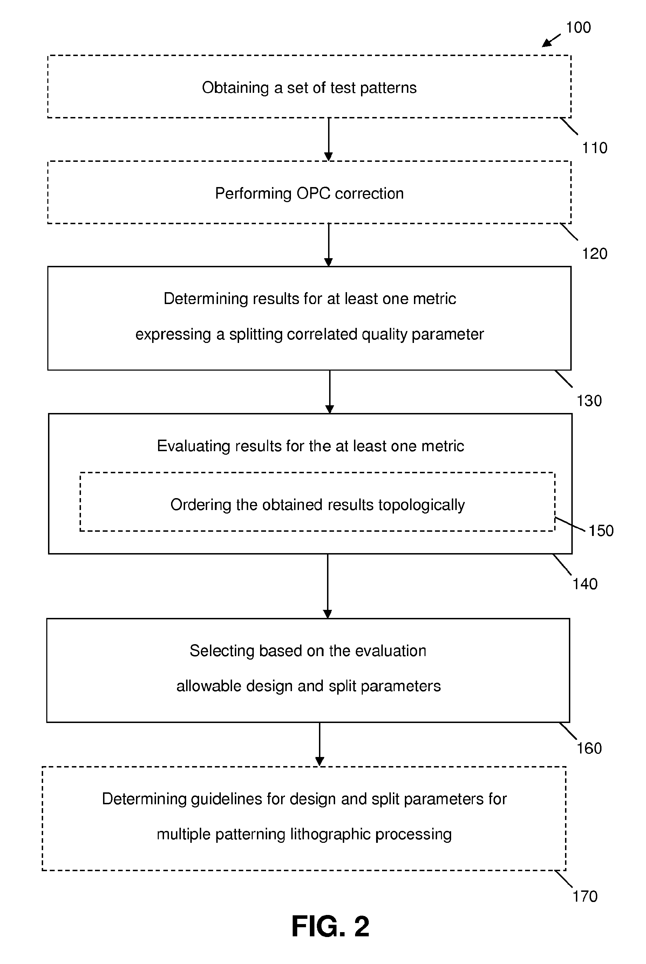

By way of illustration, the present invention not being limited thereto, an overview of standard and optional steps according to a method for optimising e.g. setting up multiple patterning lithographic processing 100 is shown in FIG. 2.

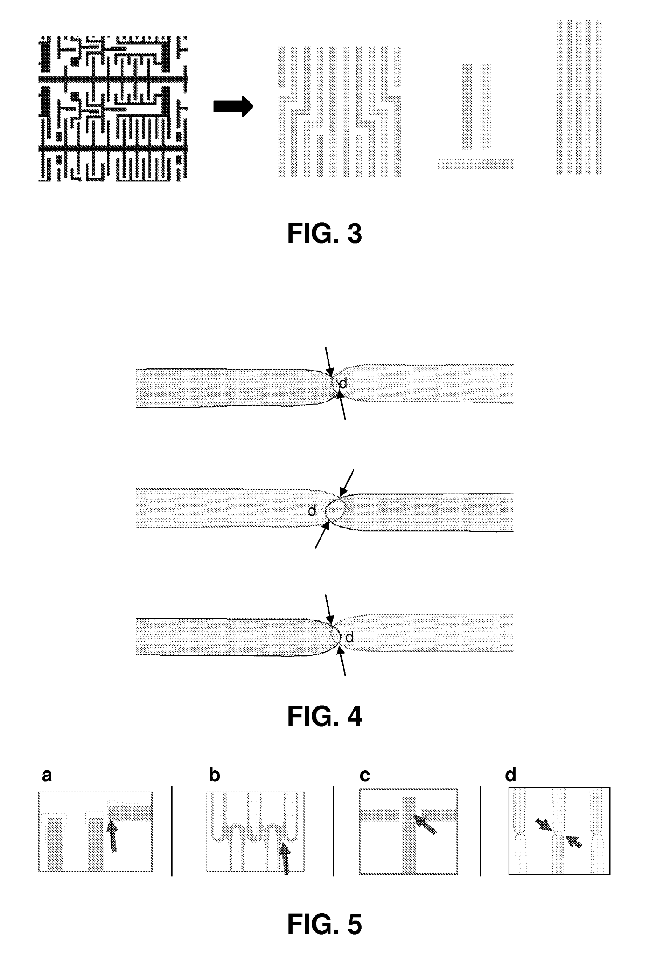

As the determination of the at least one metric expressing a degree of splitting, e.g. stitching, or expressing a splitting or stitching correlated process quality advantageously may be performed on a set of test patterns, the method 100 may comprise in a first step 110 obtaining representative two dimensional test patterns. Such test patterns may comprise generic structures for the application of interest. By performing the method on test patterns, split and design parameters and guidelines for these parameters may be derived more efficient then when a real pattern to be patterned would be used in the optimisation method. The test structures advantageously comprise features wherein a variation of design parameters is present, such as for example a variation in pitch, target critical dimension, gaps, topology, etc. The test structures also may comprise features split so that a variation of split parameters for the features is present. Such features may be split in at least first sub-features to be patterned in at least a first step and at least second sub-features to be patterned in at least a second step. The variation of split parameters may for example be a variation in split position, variation in stitching overlap etc. The test structures may be implemented as layout or they may be implemented as physical structures on a mask. The test patterns used for the structures may be particularly designed, may be obtained from a database, may be obtained from previous experiments, etc. For example, in one embodiment, the test patterns may be topologically organised. Such topological organisation may be such that test patterns having a variation in a value for one parameter while having the same values for other parameters are positioned equidistant from each other or positioned at fixed or systematically varied distances. In other words, for a systematic variation of the one parameter value between different test patterns, a systematic distance variation between the position of the test patterns may be used. The topological organisation may be in matrix format. The latter will be discussed in more detail in a number of examples set out below. The test patterns may be particularly selected so as to provide appropriate information for applications of interest, e.g. for the patterning of random logic patterns. The test patterns used may be such that design and split parameters are varied systematically. By way of illustration, embodiments of the present invention not being limited thereto, an application of interest indicating a 45nm half pitch random logic metal layout and possible test patterns that can be used therefore are shown in FIG. 3. The.45nm half pitch random logic metal layout is shown at the left hand side, while three possible test patterns are shown at the right hand side.

In another optional step 120, the method may comprise performing an optical proximity correction (OPC) for one selected patterning process. OPC may be performed in a conventional manner, e.g. by using a calibrated resist model or e.g. by using a non-calibrated resist model, such as a non-calibrated constant threshold resist model, although the invention is not limited thereto. Alternatively or in addition thereto, parameters describing an optional optical proximity correction may be incorporated in the determination of the metric expressing a stitching correlated process quality. Parameters describing the optical proximity correction therefore may be considered design parameters and used in the metric determining step 130.

In step 130, the method comprises determining results for at least one metric expressing a splitting correlated process quality, e.g. a stitching correlated process quality. The latter is performed as function of design parameters of the pattern and/or as function of split parameters for the multiple patterning process, e.g. by using different test structures for obtaining such values for the at least one metric and/or by using different sub-features for the first patterning step and an at least second patterning step. Obtaining results furthermore may be performed as function of different process conditions, i.e. for a plurality of process conditions. The different process variables that may be taken into account may be any variable expressing the variation of the patterning process such as for example the illumination conditions in general, the dose, the depth of focus, the illumination source used, the overlay on the wafer, etc. Obtaining results for the metric may be achieved based on simulations with a calibrated model, based on experiments, based on aggregate imaging system (AIMS) measurements. Simulations may be performed using any conventional simulation packet for lithographic patterning such as for examle Prolith™, Solid E™, Mentor OPC Verify™ or Synopsis SiVl™. The results of the metric may be expressed as a value for the metric, e.g. a numerical value for the metric. The at least one metric expressing a splitting, e.g. stitching, correlated process parameter may advantageously be the stitching width. The stitching width may be the smallest internal distance between merged contours of the design features patterned in the first patterning step and the design features patterned in at least the second patterning step. By way of illustration, the present invention not being limited thereto, an example of how the stitching width is defined is shown in FIG. 4. The distance is indicated for three different stitches, being the (smallest) distance between the two arrows. It is an advantage of embodiments according to the present invention that the splitting, e.g. stitching, parameters and design parameters derived with these methods are not only good under optimum process conditions, but that the yield obtained through process variations still is sufficiently high. The stitching quality therefore is judged based on a metric determined under various process conditions, e.g. in detuned process conditions. The detuned process parameters may for example be obtained by varying the dose, in best focus, over a predetermined value such as for example over ± 3%, by varying the focus, in best dose, over a predetermined value such as for example over ± 50nm. Variation of the other process parameters also may be performed, such as for example varying the illumination type. Other metrics expressing a stitching correlated process quality may for example be the occurrence of or the amount of bridging or pinching that occurs at the stitching area, an electric parameter influenced by the stitching, a circuit performance influenced by the stitching, etc.

In some embodiments, the metric may be evaluated only for a limited number of parameter values, e.g. for particularly selected parameter sub-spaces, for particularly selected parameter groups and/or for particularly selected process conditions, for selected sets of process conditions, etc. When evaluating as function of a given parameter or as function of a number of parameters, predetermined sets thus may be selected, predetermined parameter ranges to be checked may be selected, predetermined parameter relationships may be taken into account, etc.

In some embodiments, as an optional step, values may be determined for other metrics. Such metrics also may express a degree of splitting, e.g. stitching, between design features. Alternatively or in addition thereto, such metrics also may express different features of the lithographic processing such as for example expressing an incomplete optical proximity correction, expressing bridging and/or pinching. These different effects, together with the aspect of stitching, are illustrated in FIG. 5.

In step 140, an evaluation of the results for the at least one metric is performed. Such an evaluation may express whether or not the obtained results correspond with a sufficiently good lithographic processing result or not. Such an evaluation may comprise defining process failure flags. Such process failure flags may indicate whether or not the determined results for the at least one metric are according to predetermined criteria. In addition to dose, focus and mask errors, stitching can suffer from overlay errors between the different patterning steps. Overlay errors may be induced in X and Y direction. Stitching may be checked between contours experiencing overlay shift, with the multiple patterning steps performed in defocus, decreased dose and downsized mask. Such criteria may be determined based on previously performed experiments, calculations, etc. One example of such an evaluation may be evaluation whether a stitching width is smaller or larger than a predetermined value. For example, in certain experiments, an insufficient splitting, e.g. stitching, quality and corresponding therewith an insufficient lithographic processing quality may be determined by a stitching width being smaller than a predetermined value, such as e.g. smaller than 90% of the nominal critical dimension obtainable or 60% of the nominal critical dimension obtainable or 30% of the nominal critical dimension obtainable or 10% of the nominal critical dimension obtainable.

The evaluation may be expressed as binary result, indicating either sufficient or insufficient quality, although also more detailed evaluation expressing intermediate quality levels for the lithographic processing may be obtained. It is an advantage of embodiments according to the present invention to use stitching width as a metric, as the area of overlap in stitching between two contours may be marginal while still a robust stitching is obtained.

FIG. 5 illustrates from left to right different process failure criteria, being an incomplete OPC (a), the occurrence of bridging (b), the occurrence of pinching (c) and the occurrence of a stitching errorn (d). The first three may be referred to as imaging failure errors. An incomplete OPC may be defined as an Edge Placement Error (EPE) that is larger than a predetermined value at a trench-end, when process conditions are in best dose, best focus and for a nominal mask. The process may for example be considered failed when the EPE is larger than 3nm at a trench-end in best dose, best focus and nominal mask. It is to be noticed that in certain polygon configurations, there is no room to extent the trench-end hammerhead far enough to fully compensate for trench-end pullback. It also is to be noticed that some bridging can happen between neighbouring contours in best focus, increased dose and upsized mask. A process failure may be considered based on bridging as soon as the contours come closer than a predetermined value, e.g. closer than 15nm. A process failure may be established based on pinching when a trench becomes critically too narrow, e.g. having an internal width smaller than a predetermined value such as for example smaller than 35nm, in defocus, decreased dose and downsized mask.

In step 150, the obtained results for the metric or the obtained evaluation for the metric results may be arranged so that an easy evaluation as function of different parameters such as design parameters and/or split parameters may be obtained. The obtained results or evaluation thereof may be organised topologically, in order to allow easy evaluation. The topologically organisation may be such that results obtained for variation of one parameter value, while others parameter values are maintained, are positioned equidistant. The latter may be performed by arranging the selected data in a multi-dimensional matrix, wherein each dimension represents a different split or design parameter taken into account. This optional step will be illustrated in more detail below.

In step 160, suitable design and split parameters are determined for the multiple patterning lithographic processing of the pattern in a single layer, taking into account the evaluation results for the at least one process condition or optionally for a plurality of process conditions. In this way, design and split parameters can be selected such that a good process window is obtained for the multiple patterning lithographic processing that is to be performed. The latter may be obtained by selecting design and split parameters so that upon variation of the process, design and split conditions, the obtained metric results are still sufficient. When a multi-dimensional matrix representation is obtained as set out in step 150 and below, determination of suitable design and split parameters may be performed by screening the matrix for success areas, i.e. for a parameter space where a sufficient or suitable lithographic process is obtained, e.g. where no error flags are obtained.

Once the design and split parameters are determined for the multiple patterning lithographic processing of the pattern, which preferably is a test pattern comprising test features, the obtained design and split parameters resulting in successful lithographic processing may be translated into design and split guidelines, as shown in step 170, for multiple-patterning lithographic processing of other patterns of interest. The guidelines thereby may ensure a robust multiple patterning process through process variations.

In a further step, the obtained design and split parameters may be used for obtaining an initial splitted design for a multiple patterning lithographic processing of a pattern to be processed. It thereby is an advantage of embodiments of the present invention that the initial accurate splitted design can immediately result in an accurate processed pattern fulfilling predetermined requirements for a given metric.

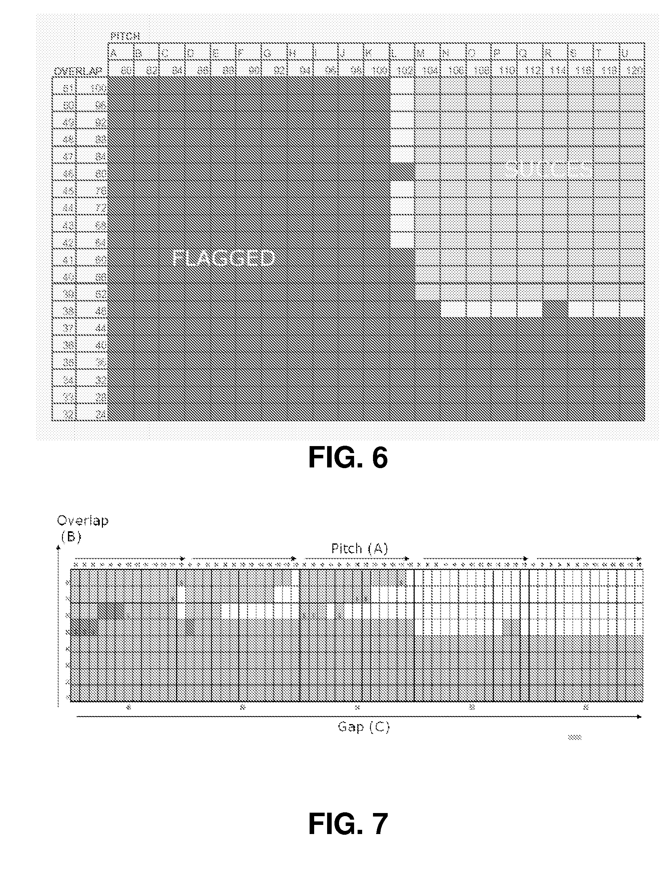

According to an embodiment of the present invention, the method furthermore comprises the optional step of arranging the obtained evaluation results or values so that an easy evaluation as function of different parameters such as design parameters and/or split parameters can be done. The latter may be obtained by using each variable in one direction, thus obtaining a multidimensional representation. The data thus may be arranged in a multi-dimensional matrix, wherein each dimension represents a different parameter taken into account. In one example the multidimensional matrix is visualised in a two-dimensional matrix representation. In this representation, the values or results for the metric are represented in a two dimensional sub-matrix as function of two variables, whereby the columns of the sub-matrix correspond with values for the first variable and the rows of the sub-matrix correspond with values for the second variable. An example thereof is shown in FIG. 6, illustrating a sub-matrix indicating for example for parallel lines a result for a metric expressing a degree of stitching as function of the pitch (varied in the different columns) and of the overlap (varied in the different lines). Dark squares are marked 'flagged', which means stitching or bridging failures occurred, whereas light squares are marked 'success', which means stitching was successful. Advantageously also other variables are taken into account. For example, in order to take into account a third variable, a sub-matrix is determined for each value of the third variable and the sub-matrix are arranged and outlined in a larger row or column matrix. In a similar way also a fourth variable can be taken into account, by determining for each value of the fourth variable that is under study a larger row or column matrix and by arranging these larger row or column matrices in the columns respectively rows of a further, larger matrix. More variables can be added in a similar way. By way of illustration, the present invention not being limited, an example of such a representation is shown in FIG. 7 illustrating a representation wherein 3 different variables are taken into account, in the present example being pitch, overlap and gap. In FIG. 7 sub-matrices are represented expressing different pitch values in the different columns and expressing different stitching overlap values in the different rows. Such sub-matrices are determined for different values of the gap between the features, and the sub-matrices for different gap values are arranged in a larger row matrix. In the matrix, it can be seen that the metric result or an evaluation thereof can be displayed. In the present example, the grey filled squares represent squares wherein stitching or bridging failures occurred. The white squares represent squares wherein stitching was successful. In another example (not shown), a fourth variable, e.g. a further split or design parameter, may be taken into account and the larger row-matrix is determined for different exposure dose /focus conditions and arranged as different rows of a larger matrix. In this way, a matrix representing the metric as function of four variables is obtained. For a metric result corresponding with a given value of the first and the second variable, the corresponding metric result for the given value of the first and the second variable but for a different value of the third variable can then easily be found in cells that are shifted over n times the sub-matrix width, whereby n is an integer number. The corresponding metric result for the given value of the first and the second variable but for a different value of the fourth variable can easily be found in cells that are shifted over m times the sub-matrix height, whereby m is an integer number. It is an advantage of embodiments according to the present invention that evaluation of metric can be obtained in an efficient way. It is to be noticed that different variables can be selected as first, second, third or fourth variable and/or that the number of variables taken into account can be varied. In one example, the matrix may for example represent the metric as function of pitch and stitching overlap for different split of zigzag at various gaps. It is also to be noticed that the metric results do not need to be determined for all cells in all sub-matrices corresponding with possible values for all variables, but that this can be user determined, based on predetermined rules, based on predetermined algorithms, based on neural networks, etc. In this way, if for example in a given sub-range for a variable no appropriate metric results are to be expected, no determination of the metric result is to be determined. The type of variables used do not need to be limited to split and/or design parameters, but also may include process parameters.

By way of illustration, the present invention will be illustrated based on a 45nm node half pitch random logic metal design, using two dimensional split test patterns, whereby the design and the split parameters of the split test patterns are varied systematically. A set of selected representative test patterns with various critical 2D topologies was used for which density and dimensions were varied in a systematic way. The splitting and cutting positions and the way to recombine (polygon overlap) were also varied. For each test pattern, large matrices with varying critical parameters were screened, leading to guidelines on best split practice and also guidelines for split compliant design.

In a first phase, image contour simulations were used to discuss the critical parameters. Those results were compared for various illumination settings at 1.2NA and 1.35NA and the corresponding OPC. The illumination settings thereby were optimised through pitch for depth of focus (DOF), mask enhanced error factor (MEEF) and image log slope (ILS) at the trench-ends of small gaps. For the optimisation, the specifics of the split patterns were taken into account. Considering k1 = 0.4 as a typical resolution limit for through pitch metal1 imaging, the pitch splitting was selected under 115nm pitch at NA=1.35, or 130nm pitch at NA=1.20. The split pitch may fall in a forbidden pitch range, which was avoided or minimized by tuning the NA and partial coherence (σ) settings. NA=1.35 helped to move the forbidden range below 180nm pitch. Increasing the resist target improved the DOF. The resolution limit for gaps was improved in order to reduce the need for polygon cuts. The image log slope ILS at small gaps as well as the MEEF of the trenches did benefit from increasing NA or σ. Based on simulations both at NA=1.2 and NA=1.35, an annular illumination setting was selected for the imaging of random logic 65nm trenches from k1 = 0.4 through pitch. σₒᵤₜ - σᵢₙ = 0.92 - 0.72 and X/Y polarization were chosen to increase the contrast at small gaps and to reduce the trench MEEF.

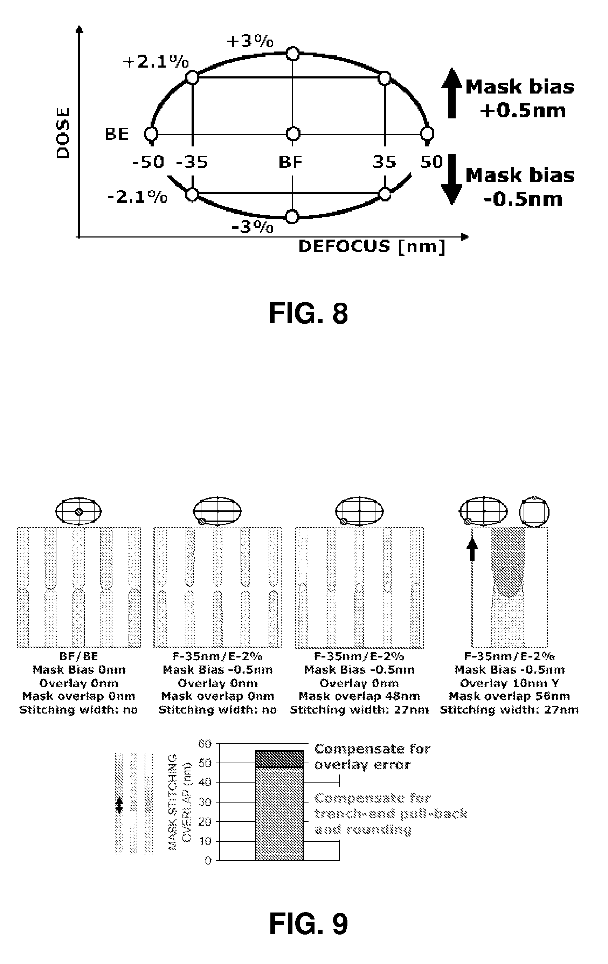

The simulation methodology used was as follows. The contours of the image in resist were simulated. The target in resist was 65nm. An isotropic constant etch bias was assumed to bring trenches down to 45nm in hard-mask. After insertion of the assist features, a dense OPC (using Mentor Graphics Calibre nmOPC) was run using a non-calibrated constant threshold resist model. The default OPC settings were used. At this stage, the two patterning steps was assumed to be independent from each other. Further the image contours were simulated and compared under various process conditions (using Mentor Graphics Calibre OPCVerify). Each patterning step was first considered separately. The dose and focus conditions were varied on 9 different positions in the centre and along the edge of an elliptical process window, as shown in FIG. 8. In best focus, the dose was varied by ±3%; in best dose, the focus was varied by ±50nm; the dose and the focus were also varied concurrently by ±2.1% and ±35nm respectively. As MEEF is critical for trenches and certainly at trench-ends, a ±0.5nm mask bias variation per edge, additionally to the dose variations, was induced. When the dose was increased, the OPC'ed mask polygons were upsized by 0.5nm. Similarly, the mask was down-sized when the dose was decreased.

The simulations were run at NA = 1.35 with annular illumination σₒᵤₜ 0.92 - σᵢₙ 0.72 and X/Y polarised light, unless noted otherwise.

A stitching overlap (overlap at mask level between the polygons from patterning 1 and patterning 2) is needed to ensure a stitching without process failure flag. First the stitching in dense parallel lines (110nm pitch) cut in the middle was considered, as can be seen in FIG. 9. At nominal mask overlap of 0nm, the contours from the two patterning steps touched each other without overlapping. In defocus, decreased dose, and downsized mask, the trench-end pullback resulted in a gap between the two patterns to be compensated by some mask overlap. In "detuned" process, a 48nm overlap was needed to compensate not only for trench-end pull back but also for trench-end rounding, in order to obtain an acceptable stitching width according to the failure-flag defined. If a worst-case 10nm overlay error was induced along the stitching direction, the stitching overlap needed to be increased up to 56nm in order to avoid the stitching failure. It is shown based on this example that the mask stitching overlap is mainly compensating for the variations of trench-end and shape through process variations, more than for overlay, as can be seen in FIG. 9. The trench-end process is more critical for stitching than overlay, while overlay remains critical for the pattern placement. From the example, it is also suggested that more specific OPC or resolution enhancement technique (RET) should be used to ensure better trench-end pattern fidelity.

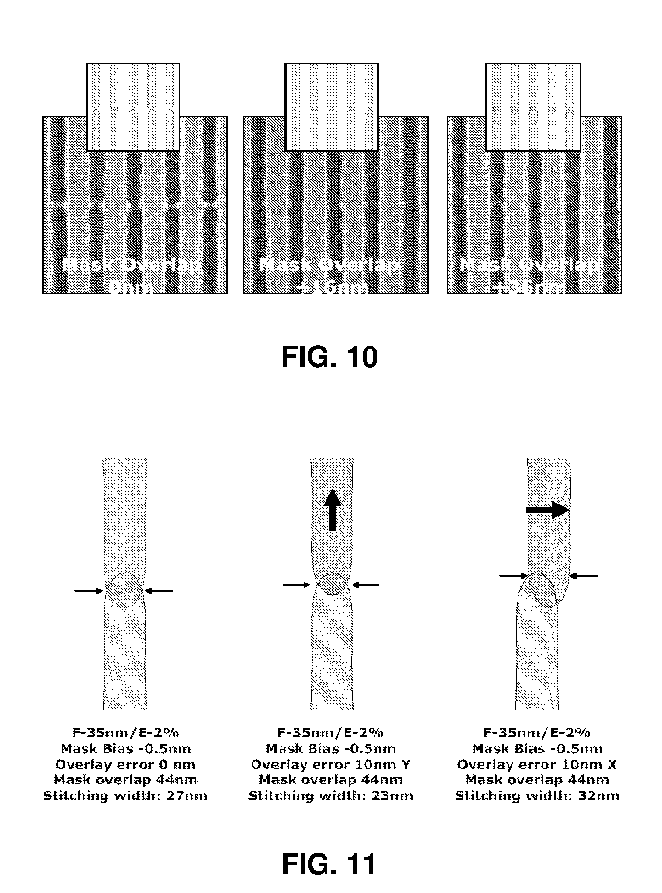

The stitching in parallel trenches is illustrated in FIG. 10 by experimental results at NA=1.20 in best dose, best focus, nominal mask. An insufficient stitching width was observed at mask overlap 16nm, showing necking. Further increasing the mask overlap up to 36nm, the difference between patterning 1 and 2 could be barely seen. In addition, 8nm of trench-end pull-back needed to be compensated in detuned process. Based on this, the needed mask overlap was estimated around 50nm (36nm plus two times the pullback of 8nm).

It is also interesting to notice that an overlay error perpendicular to the stitching direction could be beneficial to the stitching width (FIG. 11). Having stitching both in X and Y direction, it means that X and Y overlay specs should be minimized, but not the diagonal specs: the overlay process window is a square instead of a circle when considering stitching.

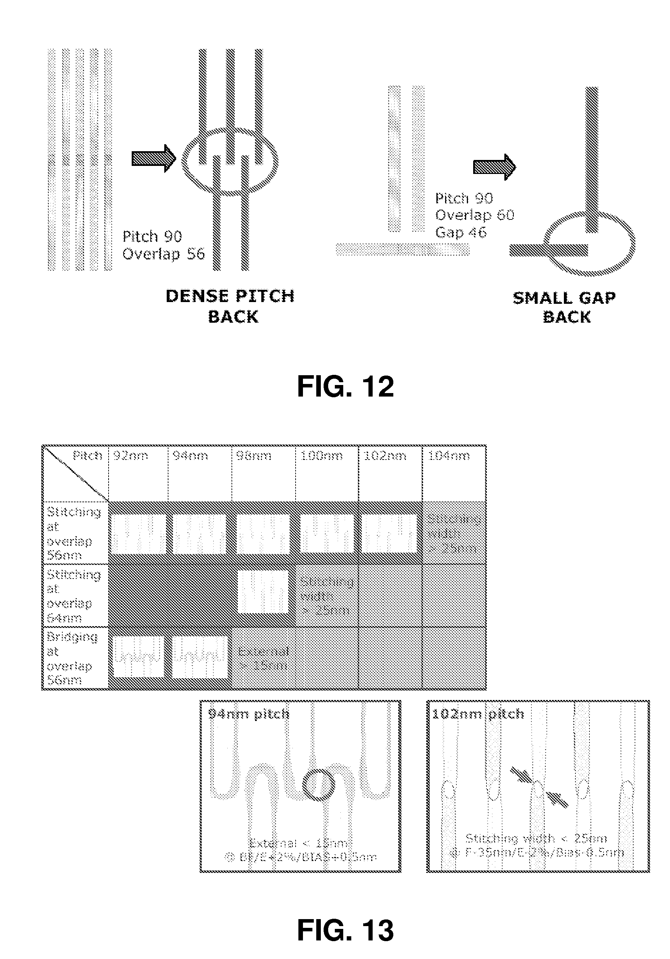

Further to the cut in parallel trenches, as well as the cut in perpendicular trenches as depicted in FIG 12. In both cases, a polygon cut occurs next to a small space (small pitch) or next to a small gap, both removed by design split. However the overlap needed for a robust stitching reintroduces locally the small pitch or small gap. Consequently, such cuts limit the benefits of double patterning. The different reasons for failures were investigated. For the parallel trenches at NA=1.35, the simulations showed that a minimum mask overlap of 56nm is required. Due to the cut in the parallel trenches, the 104nm pitch was the last one without process failure (FIG. 13). A stitching failure was found for pitch 102nm and below, which is explained by a lack of process at the trench-end intended for stitching overlap. Increasing the overlap to 64nm moved the pitch limit down to 98nm, but further increasing it did not help. A bridging problem also occurred from pitch 94nm onwards when trench-ends come too close to each other with insufficient exposure latitude.

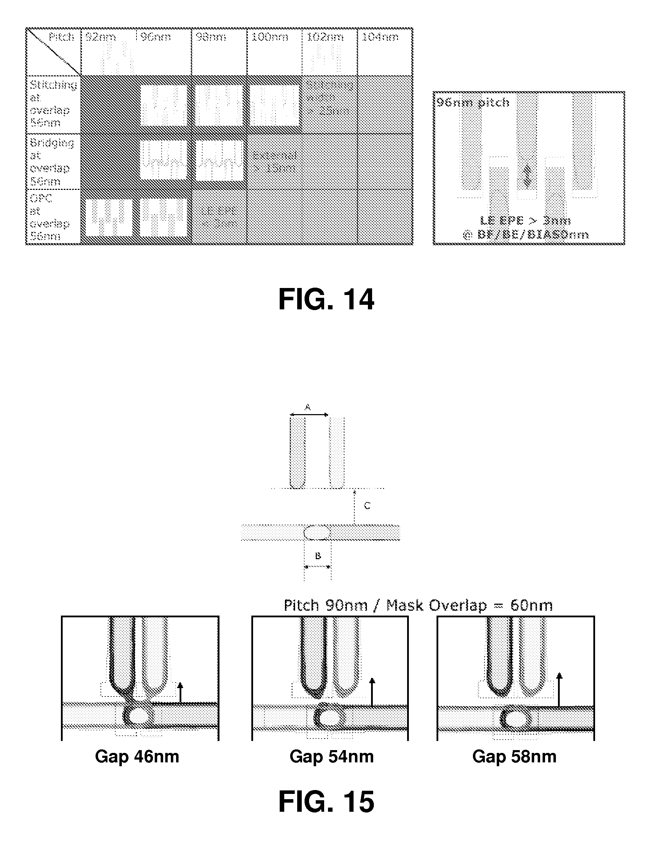

Analyzing the same parallel trenches with cut at a reduced NA=1.20, requiring the same mask overlap of 56nm, the 102nm pitch was the last one without process failures. The stitching issues began at 100nm pitch. This marginal improvement compared to NA=1.35 was explained by the increase in DOF. Moreover, the bridging problems occurred at larger pitch, i.e. 98nm pitch, indicating an increased lack of exposure latitude at the trench-end intended for overlap. An additional issue occurred at 96nm pitch when the OPC could not be fully completed resulting in an EPE > 3nm. The stitching overlap made the trench-end sub-resolution at pitches below 96nm. Thus, at NA=1.20 the large overlap re-introduced the dense pitch, resulting in stitching, bridging and OPC failures as can be seen in FIG. 14. The sources of failure appeared at different pitch, but there was no real change in terms of minimum pitch for a robust stitching compared to simulations at NA=1.35.

In conclusion, to take full advantage of the double patterning to drastically improve the pitch resolution in parallel trenches, any stitching should be avoided. If stitching is needed for parallel lines , then the pitch needs to be relaxed to allow a robust stitching though process variations.

A similar analysis was run on the perpendicular trenches configuration, called "double T-shape". Pitch, gap and stitching overlap were varied, referred as parameters a, b, and c in FIG. 15. Based on the analysis of the parameter space for no process failure at NA=1.35, we show that the gap needs to be relaxed to make the minimum overlap for stitching possible. In case of a gap larger or equal to 58nm, the pitch 88nm can be achieved by double patterning with a 60nm minimum overlap in the horizontal line. If the gap further increases to 62nm, the minimum overlap can be reduced down to 50nm.

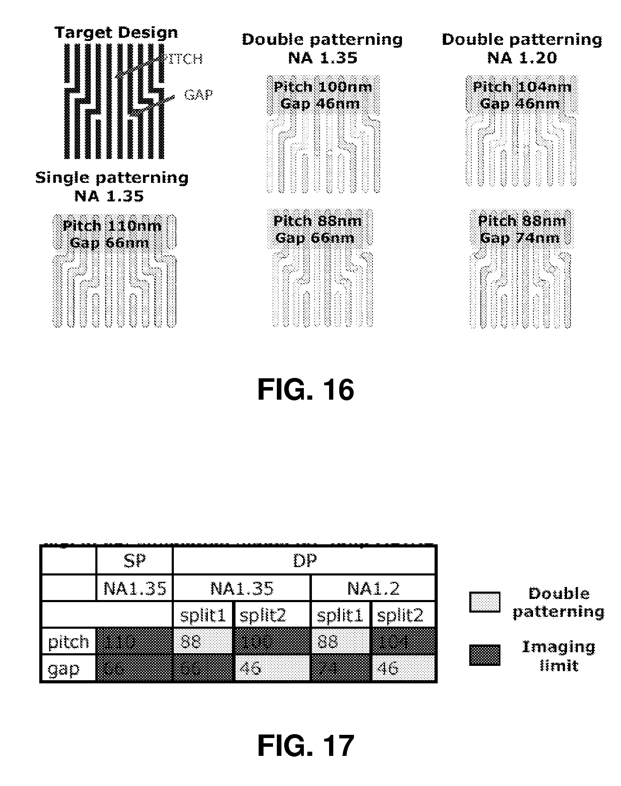

The situation of a combined aggressive pitch and gap was also studied.
The pattern displayed in FIG. 16 is typical for a metal1 layer and it combines both the pitch and the gap at their minimum target of 90nm and 46nm respectively. The test design is such that pitch, gap, cut position and stitching overlap are varied. The densest pitch and gap combinations free of failure flags were identified and compared for single patterning, double patterning at NA=1.35 and double patterning at NA=1.20, using the same failure criteria in the three cases. Each litho step of the double patterning flow targeted at 65nm trenches at a minimum pitch of 115nm to 130nm, using assist features and assuming an etch bias down to 45nm. The single patterning targeted at 45nm trenches at 90nm minimum pitch, while the trenches could be retargeted as the pitch is relaxed, it did not use any assist features. Using single patterning at NA=1.35, the minimum pitch of 110nm and minimum gap of 66nm were such that no process failure was observed using our simulation model. Denser pitch or gap would lead to failures. Using the double patterning at NA=1.35, two cut positions were possible. The aggressive gap target could be achieved by double patterning, resulting in a need for cutting the two central parallel trenches. However the pitch should be relaxed above 100nm to ensure a robust stitching. This constrains on the pitch concerned the trenches around the stitching area. However, if no cut of the parallel trenches was allowed, the target pitch of 90nm was achievable with double patterning of the complete trenches. As a result the small gaps have to be printed at the same litho step, limiting the minimum gaps to 66nm. A similar analysis at NA=1.20 has lead to similar conclusions. If a cut was used into the parallel lines, a minimum pitch of 104nm ensures a robust stitching. On the contrary if the gap needed to print in one imaging step, then it should be relaxed to 74nm. Decreasing the NA resulted in a worse gap resolution, increasing the need for cuts. As a conclusion, a significant resolution improvement using double patterning was only possible if the stitching did not occur next to a small space (dense pitch) or to a small gap (FIG. 17).

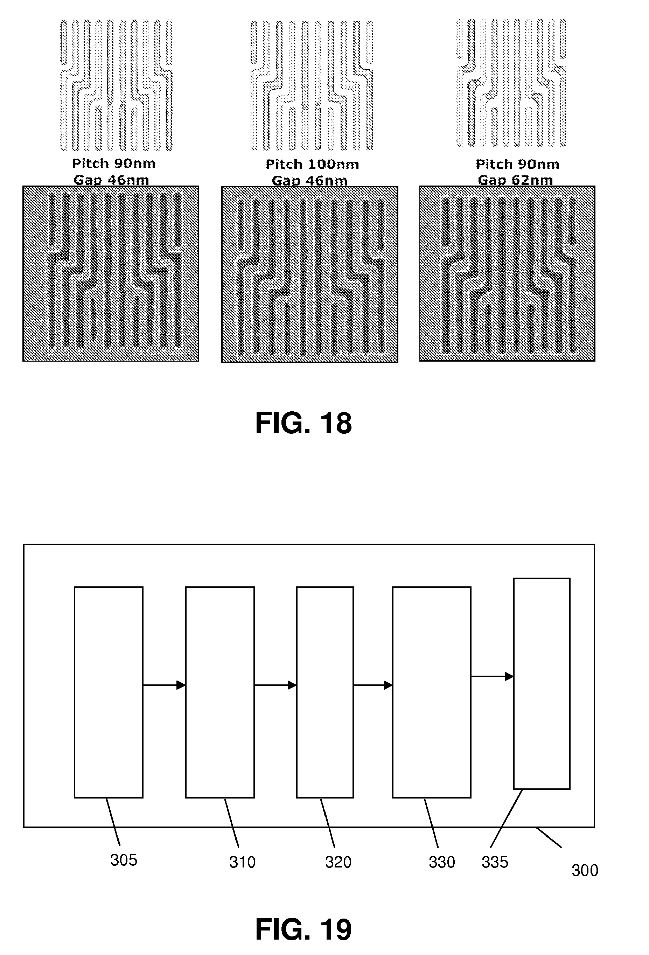

FIG. 18 shows the patterning of the test pattern at NA=1.20 using double patterning in best dose, best focus, nominal mask. At pitch 90nm / gap 46nm, the stitching width in the middle of the parallel lines was too narrow, being already an indication for failure in detuned process. Stitching was improved when relaxing the pitch up to 100nm, where very aggressive gaps ∼45nm were patterned with double patterning. If the gap was relaxed to ∼60nm, the stitching occurred in the middle of the turns, and the 90nm pitch was patterned using double patterning.

In conclusion the above example illustrates that the design split problem is more than just polygon cutting and coloring. The polygons need to recombine through the double patterning process flow (=stitching). Whereas OPC can ensure some overlap under optimum process conditions, the yield might decrease under a detuned process due to failing stitching. The example illustrates a developed methodology to study the double patterning stitching robustness through process variations according to embodiments of the present invention. Design and split parameters of representative test patterns thereby were varied in a systematic way. Process failures due to variations in dose, focus, mask CD and overlay were defined and flagged. Based on simulations, the parameters space free of process failure flags was identified. The parameter space for success was used to indicate best split practice or design guidelines to ensure a robust stitching for maintaining yield with double patterning. The trench-end process (pattern fidelity and position) was critical to stitching, more than overlay was. Advantageously, sufficient attention is paid to the line- and trench-end process, using adequate RET (including OPC) to increase pattern fidelity and process latitude. Of course, the overlay remains critical for the pattern placement, rather than for stitching. A global scaling from the previous node did not allow taking full advantage of the double patterning. The pattern split was required due to dense pitch (=small space) or small gap. If cutting and stitching were required next to a split space or gap, the overlap required for robust stitching re-introduced locally the initial minimum target space or gap. In consequence the benefit of the split was partially cancelled. The stitching robustness could be ensured by adequately relaxing the minimum local gap or space target. Note that reducing the amount of stitching overlap limited the need for design relaxation. Basically, it was the imaging resolution at stitching that limits the benefit of double patterning. For example, according to the simulation model, the cutting and stitching limited the pitch at 100nm/104nm at NA=1.35/1.20 or the gap at 66nm/74nm at NA=1.35/1.20. However, compared to the single patterning limits, i.e. under our simulation model 110nm pitch / 66nm gap at NA1.35, the double patterning afforded significant benefits in terms of resolution, based on proper design restrictions assuming a partial design shrink where the densest pitch and densest gap were not combined at the same location in the target design. A typical limit for through pitch single patterning of a metal1 layer was found to be k1∼0.4. Under the assumptions of the simulation model, it was shown that unrestricted design would limit the benefit of double patterning to k1∼0.35. However, if some compliant design rule restriction were followed, the 45nm hp resolution limit at k1∼0.30 could be reached using double patterning, with the potential to reach more aggressive pitch or gaps.

As both single and double patterning required restricted design rules to ensure a robust imaging at k1∼0.30, the ease of their respective implementation will depend on the compliance of the 45nm hp target design and on the process itself. However, moving down to the 32nm hp applications, the only solution with 1.35 NA ArF water immersion lithography (i.e. k1=0.224) appeared to be double patterning with compliant designs to maintain the yield.

The results were also validated experimentally. A test mask was patterned at NA=1.20 using a metal Litho-Etch-Litho-Etch (LELE) double patterning process flow. The experiments confirmed the results obtained from simulation, i.e. the methodology to obtain guidelines for a representative double-patterning process flow, taking also process effects into account. The process effects thereby are inherently taking into account in the guidelines that are determined.

Following particular aspects were found. Double patterning leads to denser pitch and gaps compared to single patterning. Both benefits are not always obtainable together. In order to pattern the denser pitch, stitching in parallel lines should be avoided. It also has been found that making a jog larger helps to increase the stitching quality. A stitching failure in a jog can be due to an insufficient overlap or to a limited process jog length. It furthermore has been found that an overlap at cut positions is needed to compensate for the line-end pullback and line-end shape, even more than for the overlay error. Both simulations and experiments were used to compare the patterning of 2D split test patterns varied in a systematic way.

It is an advantage of embodiments according to the present invention that guidelines for split and design parameters can be obtained independently of the implementation of split by EDA vendors and designers.

In a second aspect, the present invention also relates to a system for optimising multiple patterning lithographic processing of a pattern in a single layer comprising a plurality of design features, e.g. for setting up multiple patterning lithographic processing of a pattern in a single layer. Such multiple patterning lithographic processing may be double patterning lithographic processing or it may comprise more than two patterning steps. The multiple patterning lithographic processing thus may comprise at least a first patterning step and a second patterning step. By way of illustration, the present invention not being limited thereto, an exemplary system is shown in FIG. 19. The exemplary system 300 comprises a metric determination means 310 for determining, for a plurality of processing conditions, results, e.g. values, for a metric expressing a splitting correlated process quality, e.g. a stitching correlated process quality, such as for example a degree of stitching between design features patterned in a first patterning step and design features patterned in a second patterning step. Alternatively, the metric may be any process property influenced by the splitting, such as for example an electric parameter, a pattern parameter, a circuit yield, reliability, etc. Such a metric advantageously may be the stitching width, as defined above. The system 300 furthermore comprises an evaluation means 320 for evaluating the results for the at least one metric as function of design and/or split parameters, taking into account the process conditions. Evaluation may be performed as function taking into account a plurality of process conditions. Furthermore, the system 300 may comprise a selection means 330 for selecting based on the evaluated results, particular design and split parameters for particular applications or for deriving guidelines for design and split in multiple patterning lithographic processes. The determination, evaluation and/or selection means may be operated in an automatic and/or automated way. It may operate according to predetermine algorithms, using a look up table, using a neural network, etc. The system 300 furthermore may comprise an input means 305 for receiving either test pattern in layout, or in print, or test results or simulation results, on which the determination of the metric results may be performed. The system furthermore may comprise an output means 335 for putting out design parameters and/or split parameters and/or for putting out guidelines for design and/or split parameters based on the selected design and/or split parameters. The system furthermore may be adapted for providing the outputted guidelines for design and/or split parameters to a system for determining an initial splitted design for a pattern of interest to be processed based on these guidelines. Other components and features may be incorporated that are adapted for performing one or more steps of the method for optimising the multiple patterning lithographic process. The same features and advantages as set out in the first aspect may be present.

In a third aspect, the present invention also relates to a design comprising a set of test patterns adapted for optimising, e.g. assisting in setting up, multiple patterning lithographic processing. Such a design may for example be available in electronic format in printed format. The design may be adapted for use in a method according to any of the above described method embodiments. It may be adapted for providing deriving therefrom values for at least one metric expressing a splitting correlated quality parameter, such as for example a degree of splitting, e.g. stitching, between design features patterned in a first patterning step and design features patterned in an at least second patterning step of a multiple patterning lithographic processing method. The test patterns may be adapted so that such values can be derived as function of design parameters and/or possible split parameters in a multiple patterning lithographic processing. In an advantageous embodiment, the test patterns may be grouped so that a plurality of test patterns is present each with a different design parameter or adapted for use with a different split parameter.

The test patterns preferably comprise one, some or all of the following structures : a set of parallel lines, a set of lines making a corner, a set of lines making at least two corners, e.g. resulting in a zigzag structure or a jog. Further features may be as set out in the following examples, embodiments of the present invention not being limited thereto.

By way of illustration, the present invention not being limited thereto, a number of examples of suitable test patterns that may be used are discussed in the following examples.

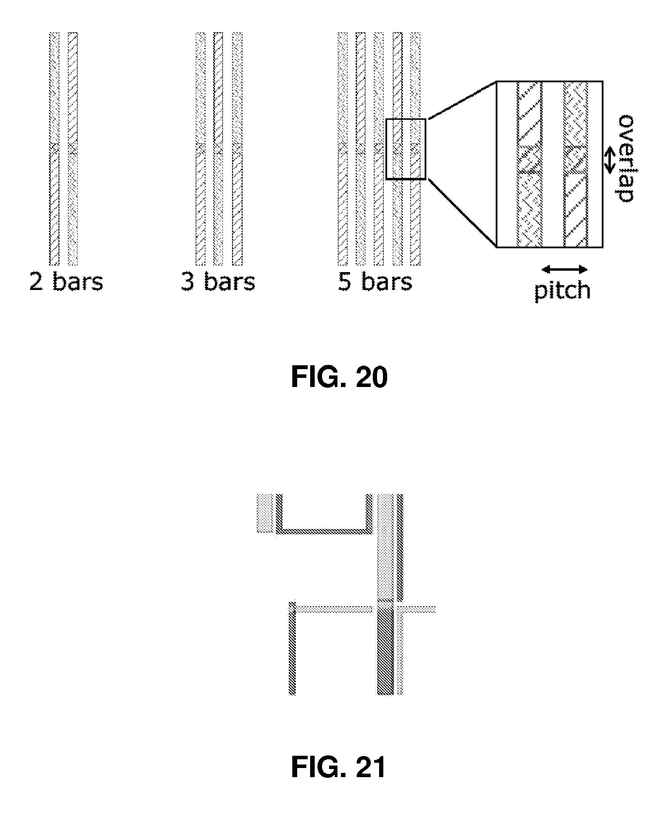

In a first example, a test pattern for use for optimising multiple patterning lithographic processing is a set of parallel lines. The test pattern thereby is cut in the middle in between the parallel lines. For these parallel lines, the dimensions, pitch and overlap have been varied. For a given set of process conditions, in the present example being a numerical aperture of 1.35, an annular illumination in the range σₒᵤₜ 0.92 - σᵢₙ 0.72 and illumination having X/Y polarisation, a splitting correlated process quality parameter has been evaluated as function of pitch and overlap. It has been found that a minimum pitch of 104nm is necessary. Varying the process parameters by using a numerical aperture of 1.20 instead of 1.35 did not result in a variation of the minimum pitch required. It has been found that the stitching robustness depends mainly on the line-end shape and on the relative position and the variations thereof through process variations. More particularly, one or more of the following characteristics can be taken into account : line-end pull-back for the lines patterned, corner rounding at the line-end, width at the line-end the amount of necking versus stitching overlap, etc. An example of such a test pattern comprising a set of parallel lines is shown in FIG. 20.

In a second example, a test pattern comprises lines shaped so as to form at least two corners, combining aggressive pitch and gap. The lines may for example be zigzag lines, as indicated in FIG. 21. A structure with a 110nm pitch and a gap of 66nm has been used whereby the double patterning limits with no failure through process variation is obtained. The double patterning is performed for processing conditions comprising a numerical aperture of 1.35, an annular illumination of σₒᵤₜ 0.90 - σᵢₙ 0.72, an illumination having an X/Y polarisation. The scaling of both the pitch and the gap is not possible in this zig-zag. The design needs to be adapted to avoid over-constrained topologies, i.e. to avoid aggressive gaps next to aggressive pitch. It has been found that keeping larger gaps, and thus avoiding the need for stitching in the dense parallel trenches, allows reaching the target at 90nm pitch. Furthermore small gaps are possible at looser pitch.

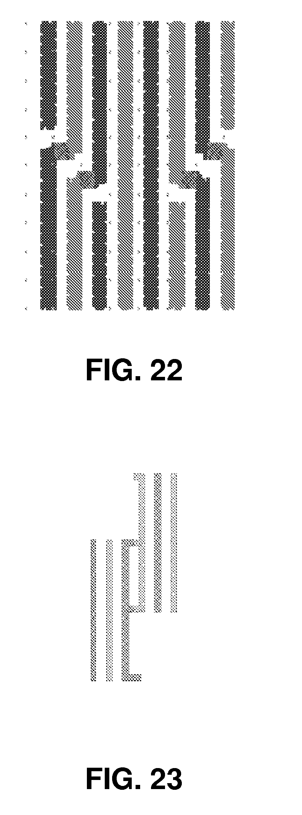

In a third example, a test pattern comprises a corner. Double patterning lithographic processing is performed using a numerical aperture of 1.5 and with annular illumination of σₒᵤₜ 0.90 - σᵢₙ 0.72 and X/Y polarisation. It has been found that the minimum pitch is limited by bridging problems due to stitching overlap in dense parallel lines. A minimum pitch of 98nm to 100nm can be obtained by increasing the gap. The corner-to-corner bridging limits the gap. An example of such a test pattern is shown in FIG. 22.

In a fourth example, a test pattern comprising a jog is studied. The test pattern is tested under processing conditions of a numerical aperture of 1.35, an annular illumination of σₒᵤₜ 0.92 - σᵢₙ 0.72 and an X/Y polarisation. It has been found that for a width of 88nm and an overlap of more than 19nm and for a width of 66nm and an overlap of more than 20nm any cut is fine. When using a jog with a length around 70nm, this results in a stitching failure. Overall it has been found that enlarging the jog and ensuring minimal overlap, any cut position at any pitch is ok. For a 44nm jog, the cut position advantageously can be chosen so that no bridging occurs between the jog-end and the next line. Furthermore, the jog length should not be too short but also not be between 70nm and 90nm. An example of such a test pattern is shown in FIG. 23.

In a fourth aspect, the present invention relates to a method for multiple patterning lithographic processing of a pattern in a single layer according to a design comprising a plurality of design features according to design parameters. The method thereby comprises a step of splitting a design according to predetermined split parameters in a first set of design features and in a second set of design features and performing a first patterning step for the first set of pattern features and a second patterning step for the second set of design features, whereby the predetermined split parameters and the design parameters are determined using a method according to a method for optimising, e.g. setting up a good lithographic process, as described in the first aspect.

In a fifth aspect, the present invention relates to a set of masks for multiple patterning lithographic processing of a pattern in a single layer. The set of masks thereby comprise a first mask comprising a first set of design features of the design to be patterned in the pattern and a second mask comprising a second set of design features of the design to be patterned in the pattern, whereby the masks are made according to predetermined split and design parameters obtained using a method for optimising, e.g. setting up a good lithographic process, as set out in the first aspect.

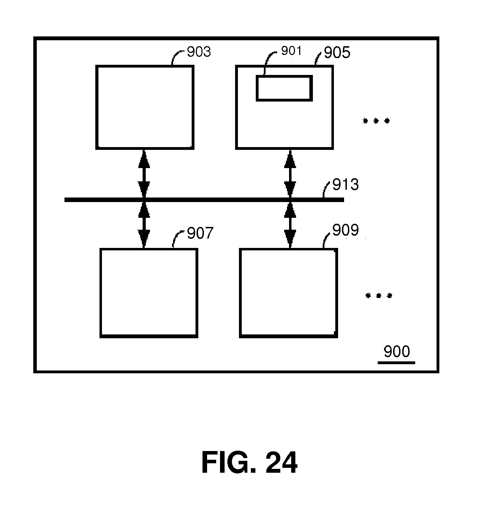

The above-described method embodiments of the present invention may be implemented in a processing system 900 such as shown in Fig. 24.
Fig. 24 shows one configuration of processing system 900 that includes at least one programmable processor 903 coupled to a memory subsystem 905 that includes at least one form of memory, e.g., RAM, ROM, and so forth. It is to be noted that the processor 903 or processors may be a general purpose, or a special purpose processor, and may be for inclusion in a device, e.g., a chip that has other components that perform other functions. Thus, one or more aspects of the present invention can be implemented in digital electronic circuitry, or in computer hardware, firmware, software, or in combinations of them. The processing system may include a storage subsystem 907 that has at least one disk drive and/or CD-ROM drive and/or DVD drive. In some implementations, a display system, a keyboard, and a pointing device may be included as part of a user interface subsystem 909 to provide for a user to manually input information. Ports for inputting and outputting data also may be included. More elements such as network connections, interfaces to various devices, and so forth, may be included, but are not illustrated in Fig. 24. The various elements of the processing system 900 may be coupled in various ways, including via a bus subsystem 913 shown in Fig. 24 for simplicity as a single bus, but will be understood to those in the art to include a system of at least one bus. The memory of the memory subsystem 905 may at some time hold part or all (in either case shown as 911) of a set of instructions that when executed on the processing system 900 implement the steps of the method embodiments described herein. Thus, while a processing system 900 such as shown in Fig. 24 is prior art, a system that includes the instructions to implement aspects of the methods for optimising, e.g. setting up, multiple patterning lithographic processing of a pattern in a single layer is not prior art, and therefore Fig. 24 is not labelled as prior art.

The present invention also includes a computer program product which provides the functionality of any of the methods according to the present invention when executed on a computing device. Such computer program product can be tangibly embodied in a carrier medium carrying machine-readable code for execution by a programmable processor. The present invention thus relates to a carrier medium carrying a computer program product that, when executed on computing means, provides instructions for executing any of the methods as described above. The term "carrier medium" refers to any medium that participates in providing instructions to a processor for execution. Such a medium may take many forms, including but not limited to, non-volatile media, and transmission media. Non volatile media includes, for example, optical or magnetic disks, such as a storage device which is part of mass storage. Common forms of computer readable media include, a CD-ROM, a DVD, a flexible disk or floppy disk, a tape, a memory chip or cartridge or any other medium from which a computer can read. Various forms of computer readable media may be involved in carrying one or more sequences of one or more instructions to a processor for execution. The computer program product can also be transmitted via a carrier wave in a network, such as a LAN, a WAN or the Internet. Transmission media can take the form of acoustic or light waves, such as those generated during radio wave and infrared data communications. Transmission media include coaxial cables, copper wire and fibre optics, including the wires that comprise a bus within a computer.

It is to be understood that although preferred embodiments, specific constructions and configurations have been discussed herein, various changes or modifications in form and detail may be made without departing from the scope of this invention as defined by the appended claims. Functionality may be added or deleted from the block diagrams and operations may be interchanged among functional blocks. Steps may be added or deleted to methods described.

## Claims

1. A method (100) for setting up multiple patterning lithographic processing for processing a pattern in a single layer comprising a plurality of design features, the multiple patterning lithographic processing comprising a first patterning step and at least a second patterning step, the method comprising
for at least one process condition,
- obtaining (130) values for at least one metric expressing a splitting correlated process quality as function of design parameters of a pattern and/or as function of split parameters for the multiple patterning lithographic processing,
evaluating (140) said values of the at least one metric as function of design parameters and/or as function of split parameters taking into account said at least one process condition, and,
based on said evaluating (140), deriving (170) design and/or split guidelines for splitting patterns to be processed using said multiple patterning lithographic processing.

2. A method (100) according to claim 1, wherein obtaining (130) values for at least one metric expressing a splitting correlated process quality comprises obtaining (130) values for at least one metric expressing a stitching correlated process quality.

3. A method (100) according to claim 2, wherein obtaining values for at least one metric expressing a stitching correlated process quality comprises obtaining (130) values for a parameter expressing a degree of stitching between design features patterned in the first patterning step and design features patterned in the at least a second patterning step.

4. A method (100) according to claim 3, wherein said evaluating (140) values of the at least one metric comprises evaluating whether the stitching width (d), being the smallest internal distance between merged contours of the design features patterned in the first patterning step and the design features patterned in the second patterning step, is larger than a predetermined value.

5. A method (100) according to any of the previous claims, wherein said metric expressing a splitting correlated process quality comprises any of a circuit performance, an electric metric or a patterning metric.

6. A method (100) according to any of the previous claims, wherein for evaluating (140) said values of the at least one metric as function of a first, second and third design and/or split parameter, the method comprises topologically organising (150) said values of said at least one metric so that for a given value of the first and second design and/or split parameters, values of the at least one metric are positioned equidistant for subsequent values of the third design and/or split parameter in said topologically organised values.

7. A method (100) according to any of the previous claims, wherein said evaluating (140) values of the at least one metric comprises determining a process window for performing said lithographic processing so as to obtain a predetermined value for the metric expressing the splitting correlated process quality.

8. A method (100) according to any of the previous claims, wherein said obtaining (130) values for at least one metric is performed for a test pattern, and wherein said method further comprises, determining an initial design for a further pattern to be processed taking into account the derived design and/or split guidelines.

9. A method (100) according to any of the previous claims, wherein said method (100) further comprises, deriving working values for design settings and/or split settings for multiple patterning lithographic processing of a pattern in a single layer.

10. A design for test patterns, wherein the test pattern are adapted for use in a method (100) for setting up multiple patterning lithographic processing of a pattern in a single layer according to any of claims 1 to 9.

11. A design for test patterns comprising a plurality of features for being processed in a single layer, the design being a split design comprising a first sub-design with a first set of sub-features and at least a second sub-design with a second set of sub-features so as to obtain said plurality of features when using the design for multiple patterning lithographic processing, wherein said plurality of features have at least one parameterised property so that a systematic variation of the property between different features is present.

12. A design for test patterns according to claim 10 or claim 11, wherein said plurality of features comprise a first, a second and a third parameterised property, whereby the features are topologically organised so that features having the same value for the first parameterised property are positioned equidistant from each other, features comprising the same value for the second parameterised property are positioned equidistant and features comprising the same value for the third parameterised property are positioned equidistant from each other.

13. A set of reticles for optimising multiple patterning lithographic processing of a pattern in a single layer, the reticles comprising test patterns according to a design according to any of claims 10 to 12.

14. A system (300) for setting up multiple patterning lithographic processing of a pattern in a single layer, the pattern comprising a plurality of design features, the multiple patterning lithographic processing comprising at least a first patterning step and a second patterning step, the system comprising
a metric determination means (310) for obtaining, for at least one process condition, values for a metric expressing a splitting correlated process quality as function of design parameters of a pattern and/or as function of split parameters for the double patterning lithographic processing, an
evaluation means (320) for evaluating said values of the at least one metric as function of the design parameters and/or split parameters taking into account said at least one process condition, and
deriving design and/or split guidelines for splitting patterns to be processed using multiple patterning lithographic processing based on said evaluating.

15. A computer program product adapted for, when executed on a computer, performing the method of optimising multiple patterning lithographic processing of a pattern according to any of claims 1 to 9.
